(19) Europäisches Patentamt
European Patent Office
Office européen des brevets

(11) Veröffentlichungsnummer: **0 491 975 A1**

(12) # EUROPÄISCHE PATENTANMELDUNG

(21) Anmeldenummer: **90125288.2**

(22) Anmeldetag: **21.12.90**

(51) Int. Cl.5: **H01L 21/225**, H01L 21/316

(43) Veröffentlichungstag der Anmeldung:
**01.07.92 Patentblatt 92/27**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Treichel, Helmuth, Dipl.-Ing. (FH)**
**Weldishoferstrasse 4**
**W-8900 Augsburg(DE)**
Erfinder: **Neureither, Bernhard, Dipl.-Ing. (FH)**
**18 C Greenhill Drive**
**Fishkill, NY 12524(DE)**
Erfinder: **Fuchs, Dieter, Dipl.-Ing. (FH)**
**Bunzlauer Platz 1**
**W-8000 München(DE)**
Erfinder: **Braun, Rainer**
**Groschenweg 52**
**W-8000 München 82(DE)**

(54) **Verfahren zur Erzeugung einer definierten Arsendotierung in geätzten Gräben in Silizium-Halbleitersubstraten.**

(57) Bei einem Verfahren zum Erzeugen einer definierten Arsendotierung in Siliziumsubstraten, bei dem als Diffusionsquelle eine durch ozonaktivierte thermische Zersetzung aus der Gasphase (CVD-Prozeß) abgeschiedene Arsenosilikatglasschicht verwendet wird, werden als Ausgangsstoffe für die Zersetzung entweder sauerstoffhaltige elementorganische Silizium- und Arsenverbindungen oder entsprechende Silizium-Arsenverbindungen eingesetzt. Die AsSG-Schicht wird bei einer Temperatur zwischen 380 und 440 °C und bei einem Druck zwischen $10^3$ und $10^5$ Pa abgeschieden, danach wird das Arsen aus der AsSG-Schicht durch Tempern in das Substrat eingetrieben und schließlich wird die AsSG-Schicht entfernt. Das Verfahren wird bei der Herstellung von grabenförmigen Kondensator-Speicherzellen (DRAMs) zur definierten Substratdotierung mit steilem Dotierungsprofil verwendet und zeichnet sich u.a. durch ein günstigeres Temperaturbudget und verbesserten Substratscheibendurchsatz aus.

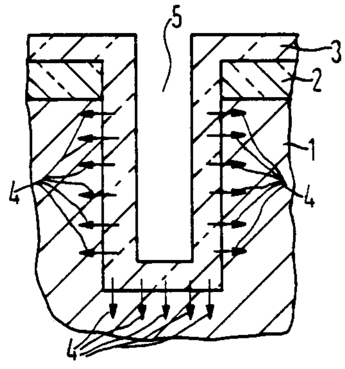


EP 0 491 975 A1

Die Erfindung betrifft ein Verfahren zur Erzeugung einer definierten Arsendotierung in Silizium-Halbleitersubstraten, vorzugsweise in Seitenwänden und Böden von in die Substrate geätzten Gräben mit hohem Aspektverhältnis, wobei als Diffusionsquelle eine in diesen Gräben abgeschiedene Arsenosilikatglasschicht verwendet wird, die nach der Arsenausdiffusion entfernt wird.

Ein derartiges Verfahren ist aus der EP-A-0271072 bekannt.

Bei der Entwicklung höchstintegrierter Bauelemente, beispielsweise dem 4- bzw. 16Mbit-DRAM, werden bei den Kondensator-Speicherzellen die planaren Zellen zunehmend wegen ihres zu großen Platzbedarfs durch Grabenzellen (Trenchzellen) mit hohem Aspektverhältnis a (a = Verhältnis von Zellentiefe zu Zellendurchmesser) ersetzt. Um die Packungsdichte der Speicherzellen weiter zu erhöhen und dabei die Speicherkapazität beizubehalten, werden Gräben mit einem Aspektverhältnis $\geqq$ 3 erzeugt, wobei für den zukünftigen 64M sogar ein Aspektverhältnis von etwa 10 angestrebt wird.

Der Einsatz dieser Trenchzellen führt vor allem dann zu einem Flächengewinn und damit zu höherer Integrationsdichte, wenn die Zellen mit möglichst geringem Abstand zueinander angeordnet werden können. Damit durch die dichte Packung der Trenchzellen die elektrischen Eigenschaften nicht verschlechtert werden, ist es wesentlich, daß die $n^+$-Dotierung (Arsen) der ersten, unteren Kondensatorelektrode den Trench mit hoher Oberflächenkonzentration, aber geringer Eindringtiefe umgibt. Dieses steile Dotierungsprofil ist nötig, um in der späteren Trenchzelle einen elektrischen Überschlag (punch-through) zu vermeiden.

Aus der EP-A-0271072 ist bekannt, daß eine geeignete Dotierung erreicht werden kann, indem der Dotierstoff Arsen aus einer im Trench möglichst konform abgeschiedenen Hilfsschicht aus Arsenosilikatglas (AsSG) durch einen anschließenden Hochtemperaturschritt (Temperung) in das Siliziumsubstrat eindiffundiert wird. Da hierbei die abgeschiedene Hilfsschicht den Dotierstoff Arsen in sehr hoher Konzentration (relativ zur späteren $n^+$-Dotierung der Elektrode) enthält, kommt es nicht wie z.B. bei Dotierungen unmittelbar aus der Gasphase (Implantation) zu lokalen Konzentrationsschwankungen im Silizium. Das bekannte Verfahren wird bei relativ hohen Temperaturen von 650 °C bis 750 °C durchgeführt, wobei als Siliziumverbindung TEOS und als Arsenverbindung TEAsat als Ausgangsstoffe für eine thermische Zersetzung verwendet werden. Die Abscheidung erfolgt in einer üblichen LPCVD-Anlage (Low pressure chemical vapour deposition). Arsen wird als Dotierstoff zur Erzeugung von Leitfähigkeitsbereichen des $n^+$-Typs gegenüber Phosphor deshalb bevorzugt, da seine um den Faktor 4 geringere Diffusionslänge kleinere Abstände der Trenches ermöglicht.

Ein Verfahren zur LPCVD-Abscheidung borhaltiger Silikatglasschichten u. a. aus solchen organischen Verbindungen, die Silizium, Bor und Sauerstoff in vorgegebenem Verhältnis bereits im Molekül enthalten, ist aus der EP-A-0339385 bekannt. Auch diese Abscheidung erfolgt bei Temperaturen um 700 °C.

Abgesehen davon, daß an die zwecks Dotierung abgeschiedenen Schichten immer höhere Forderungen hinsichtlich der Kantenbedeckung und der Konformität gestellt werden und abgesehen davon, daß die bekannten Verfahren alle mit eigenen Schwierigkeiten, z.B. zu hohem Verbrauch der Arsenverbindung oder Ausscheidung kristalliner Bestandteile im AsSG, behaftet sind, ergeben sich Probleme bei der zunehmend wünschenswerten Verwendung von größeren Waferdurchmessern.

Alle Verfahren, die auf der AsSG-Abscheidung in einem LPCVD-Verfahren mit horizontalem oder vertikalem Reaktor basieren, können die Anforderungen nach möglichst hoher Schichtgleichmäßigkeit, und homogener Abscheidung bei gleichzeitig hohem Scheibendurchsatz (z.B. 100 Scheiben/batch) nur dann erfüllen, wenn der Scheibendurchmesser nicht über 150mm hinaus ansteigt. Größere Waferdurchmesser sind aber zum einen deshalb erwünscht, da der Anteil der wegen Kristallstörungen ausfallenden Randchips abnimmt. Außerdem nimmt auch der Prozentsatz der Chips ab, die am Rande liegen und deshalb wegen der verwendeten Phototechnik nur teilweise ausgebildet werden.

Zu bedenken ist auch, daß jeder Kristall nach der Züchtung eine Reihe von Störstellen (z.B. Leerstellen oder Versetzungen) hat - umso mehr, je größer der Kristalldurchmesser - , deren Anzahl bei der Wärmebehandlung im Rahmen eines CVD-Verfahrens zunimmt. Um die Bildung derartiger Störstellen zu minimieren, muß bei zunehmendem Waferdurchmesser die Aufheiz- und Abkühlzeit ausgedehnt werden, was sich wiederum negativ auf den Scheibendurchsatz auswirkt (Prozeßzeiterhöhung von ca. drei Stunden auf ca. fünf Stunden). Generell besteht das Bedürfnis, die Abscheidetemperatur in einem CVD-Prozeß zu senken, obwohl in jedem Fall ein nachfolgender Hochtemperaturschritt notwendig ist; ersteres führt immerhin zu einem insgesamt günstigeren Temperaturbudget.

Die Vergrößerung der Scheibendurchmesser (z.B. 200mm) führt jedoch notwendig zu verlängerten Prozeßzeiten für das Aufheizen und Abkühlen, also zu einem insgesamt ungünstigeren Temperaturbudget. Je größer die Scheiben, umso größer die Gefahr von thermisch verursachten Kristallspannungen und Versetzungen, die ein vorsichtiges, d. h. langsames Aufheizen erzwingen. Auch wird es immer schwieriger, über die ganze Fläche der in sogenannten Booten im Reaktor stehenden Scheiben eine gleichmäßige

Abscheidung zu erreichen. Um andererseits trotz großer Scheibendurchmesser und langer Prozeßzeiten bei Temperaturen von etwa 700 °C trotzdem einen ausreichenden Scheibendurchsatz zu erzielen, müßten sehr viele Scheiben gleichzeitig behandelt werden. Dies ist jedoch mit den üblichen Reaktoren nicht oder nur mit Hilfe zusätzlicher komplizierter Anordnungen zur optimalen Gaszuführung und Gasverteilung möglich, wenn man den Anforderungen z. B. nach möglichst hoher Schichtgleichmäßigkeit gerecht werden will.

Es ist auch bekannt und z.B. in den Aufsätzen von Y. Nishimoto et al, "Dielectric Film Deposition By Atmospheric Pressure and Low Temperature CVD Using TEOS, Ozone and New Organometallic Doping Sources" Proc. of the IEEE VMIC Conf. (1989), S. 382-389 und P. Lee et al, "Sub-atmospheric chemical vapor deposition (SACVD) of TEOS-Ozone USG and BPSG", Proc. of the IEEE VMIC Conf. (1990), S. 396-398 beschrieben, Ozon als Oxidationsmittel einzusetzen, um dotierte oder undotierte $SiO_2$-Schichten aus elementorganischen Substanzen, insbesondere TEOS abzuscheiden. Die ozonaktivierte Zersetzung der organischen Moleküle findet als oberflächenkatalysierte Reaktion (Zerfall des $O_3$ an der heißen Substratoberfläche) direkt auf dem Substrat statt und hat so eine mit anderen Verfahren nicht erreichbare Kantenbedeckung und Konformität der abgeschiedenen Schichten zur Folge. Als Prozeßparameter werden Temperaturen bis ca. 400 °C und ein Druck im Bereich zwischen 8000Pa und 80 000Pa vorgeschlagen. Das Verfahren ist insbesondere zur Erzeugung eines dielektrischen Films zwischen einer Polysilizium- und einer Aluminiumschicht vorgesehen. Wegen der temperaturempfindlichen Aluminiumleiterbahnen muß die Temperatur auf Werte bis ca. 400 °C beschränkt werden.

In den obengenannten Aufsätzen wird z. B.auf die Frage der ozonaktivierten Abscheidung einer dotierten Passivierungsschicht eingegangen, nicht jedoch auf das technisch ganz anders gelagerte Problem, ob und gegebenenfalls wie Ozon bei der Dotierung eines Siliziumsubstrats mittels einer als Diffusionsquelle dienenden Hilfsschicht verwendet werden könnte. Insbesondere lassen sich keineswegs alle der als Isolierschichten zwischen Leiterbahnebenen oder als Passivierungsschichten verwendbaren dotierten $SiO_2$-Schichten zur Herstellung von Dotierungen mit den gewünschten Eigenschaften im Substrat einsetzen.

Aufgabe der Erfindung ist es, ein Verfahren der eingangs genannten Art anzugeben, das aufgrund einer konformen, homogen dotierten Arsenosilikatglas-Schichtabscheidung eine gewünschte Arsendotierung durch nachfolgende Diffusion in das Silizium-Halbleitersubstrat hinein auch für Waferdurchmesser von 200mm und mehr auf wirtschaftliche Weise erlaubt, und das sich darüber hinaus durch ein insgesamt günstigeres oder niedrigeres Temperaturbudget auszeichnet.

Die erfindungsgemäße Aufgabe wird durch ein Verfahren der eingangs genannten Art dadurch gelöst, daß die Arsenosilikatglasschicht durch

a) ozonaktivierte thermische Zersetzung aus der Gasphase (CVD-Prozeß)

b) einer sauerstoffhaltigen elementorganischen Siliziumverbindung und einer sauerstoffhaltigen elementorganischen Arsenverbindung

c) bei einer Temperatur im Bereich von 380 °C bis 440 °C abgeschieden wird,

d) wobei der Druck auf einen Bereich zwischen $10^3$Pa und $10^5$Pa eingestellt wird.

Erfindungsgemäß ist ein weiterer Lösungsvorschlag der Aufgabe ein Verfahren der im Patentanspruch 1 gekennzeichneten Art, bei dem abweichend davon im Merkmal b) von einer sauerstoffhaltigen elementorganischen Silizium-Arsen-Verbindung, die die Siliziumatome und die Arsenatome bereits im vorgegebenen Verhältnis enthält, ausgegangen wird. Weiterbildungen der Erfindung, insbesondere die Auswahl besonders geeigneter Substanzklassen, sowie die Verwendung des erfindungsgemäßen Verfahrens zur Herstellung von grabenförmigen Kondensatorspeicherzellen, sind Gegenstand von Unteransprüchen.

Durch die verringerte Temperaturbelastung während der AsSG-Ab-scheidung ermöglicht die Erfindung einerseits eine erhöhte Ausbeute und andererseits, durch die verringerten Prozeßzeiten, eine Scheibendurchsatzerhöhung. Die gleichmäßige und reproduzierbare Dotierung zunächst der AsSG-Schicht und dadurch später auch des Siliziumsubstrats kommt nicht zuletzt dadurch zustande, daß es durch die Verwendung sauerstoffhaltiger Silizium- (und Arsen)-Verbindungen gelingt, die Si-O-Nahordnung im Molekül auf die Struktur der sich abscheidenden AsSG-Schicht zu übertragen und mit Hilfe dieser stark oberflächenkontrollierten Reaktion eine optimale Kantenbedeckung und Konformität der AsSG-Schicht zu erzielen. Die Temperatur bei der Abscheidung wird so eingestellt, daß das Ozon an der heißen Substratoberfläche genügend rasch zerfällt und somit oberflächenkatalytisch wirken kann. Die die Qualität der AsSG-Schicht wesentlich mitbestimmende Ozon-Konzentration, die primär von der verwendeten Ozonquelle abhängt, kann z. B. durch Wahl des Druckes, der wiederum Einfluß auf die Prozeßzeit hat, auf einfache Weise in einem weiten Bereich eingestellt werden.

Im folgenden wird die Erfindung anhand zweier Ausführungsbeispiele und der FIG, die schematisch einen Graben einer Speicherzelle mit einer darin abgeschiedenen Arsenosilikatglasschicht zeigt, näher erläutert.

Die Figur zeigt einen Graben 5, der in ein mit einer Siliziumnitridschicht 2 bedecktes, aus Silizium

bestehendes Substrat 1 geätzt ist, und der beispielsweise 1µm Breite und 4µm Tiefe aufweist. In einer Anlage ähnlich der in der EP-A-0339385 in FIG 1 dargestellten Vorrichtung werden nun die diese Gräben 5 enthaltenden Substratscheiben 1, 2 auf offenen Booten durch Zersetzung einer Siliziumverbindung wie z.B. Tetraethylorthosilikat = TEOS und einer Arsenverbindung, z.B. Triethylarsenat = TEAsat mit einer Arsenosilikatglasschicht 3 belegt. Anstelle der bisher angewendeten Verfahren wird das AsSG 3 bei einer Temperatur zwischen 380 °C und 440 °C abgeschieden und durch ozonaktivierte pyrolytische Zersetzung hergestellt. Die Aufbringung der Schicht erfolgt bei einem Prozeßdruck von $10^3$Pa bis $10^5$Pa in einem konventionellen Parallelplattenreaktor. Die verdampften organischen Reaktanten werden dabei getrennt voneinander mittels Trägergas (Helium, Stickstoff oder Sauerstoff) zum Reaktor geführt und erst an der Gasdusche (showerhead) mit dem Oxidans Ozon ($O_3$) vereinigt. Typische Verdampfertemperaturen und Trägergasmengen der organischen Bestandteile sind hierbei: TEOS: 25 °C bis 60 °C/300sccm bis 2000sccm He oder $O_2$ TEAsat: 25 °C bis 40 °C/100sccm bis 1000sccm He oder $N_2$

Die Flußmengen des Ozon variieren zwischen 500sccm und 2500sccm. Die Ozonkonzentration beträgt dabei 5 bis 15Vol% in Sauerstoff. Zusätzlich kann Sauerstoff in Mengen von 0 bis 2000sccm der Reaktion beigemischt werden, um den Streß und die Gleichmäßigkeit der AsSG-Schichten günstig zu beeinflussen.

Durch Erhitzen der Anordnung (1, 2, 3, 5) auf 1000 °C wird eine Diffusion von Arsenatomen (siehe Pfeile 4) in das Substrat 1 erreicht. Nach einer Temperzeit von ca. 60 Minuten in einer 9:1 $N_2/O_2$-Atmosphäre ist der drive-in-Prozeß beendet. Das Eintreiben der Dotieratome und die nachfolgende Naßätzung sind bereits aus der oben genannten EP-A-0271072 bekannt.

Soll eine Silizium-Arsen-Verbindung, z.B. Tris(triethylsilyl)arsenat = TTESAs als Ausgangsstoff verwendet werden, so bieten sich folgende typische Verdampfertemperaturen und Trägergasmengen an:
TTESAs: 25 °C bis 90 °C / 300sccm bis 3000sccm He oder $N_2$
Da nur eine Verbindung als Ausgangsstoff verwendet wird, resultiert eine prozeßtechnisch besonders einfache Abscheidung, aber auch eine qualitativ verbesserte AsSG-Schicht mit einer besonders gleichmäßigen Dotierung.

Die bei der Abscheidung verwendeten Substanzklassen, die ein definiertes Einstellen des Silizium-Arsen-Verhältnisses der abzuscheidenden AsSG-Schicht sowohl durch die geeignete Wahl der Silizium-, der Arsen-, bzw. der Si-O-As-Verbindung als auch durch Modifikation des Restes R am Silizium erlauben, sind beispielsweise:

I. Siliziumverbindungen:

1. $Si(OR)_4$
mit R = Alkyl
z. B. $Si(OC_2H_5)_4$ Tetraethylorthosilikat = TEOS
2. $Si(OR)_3R'$
mit R = Acetoxy, Alkyl
R' = H, Alkyl

z. B. 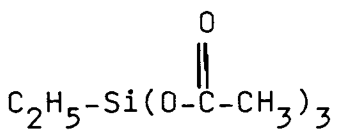 Ethyl(triacetoxy)silan

3. $(RR'SiO)_4$
mit R, R' = H, Alkyl
z. B. $(HCH_3SiO)_4$ Tetramethylcyclotetrasiloxan

II. Arsenverbindungen:

1. $As(OR)_3$
mit R = Alkyl
z. B. $As(OC_2H_5)_3$ Triethylarsenit = "TEAsit"
2. $O=As(OR)_3$
mit R = Alkyl
z. B. $O=As(OC_2H_5)_3$ Triethylarsenat = "TEAsat"

III. Si-O-As-Verbindungen:

1. $(R_3SiO)_3As$
mit R = H, Alkyl

z. B. 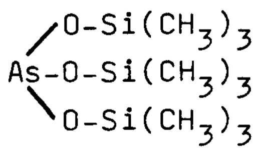 Tris(trimethylsilyl)arsenit

3. $(R_3SiO)_3As=O$
mit R = H, Alkyl

z. B. 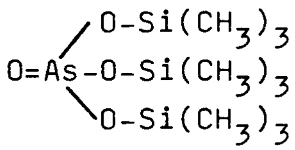 Tris(trimethylsilyl)arsenat

Die Verbindungen der aufgeführten Substanzklassen sind unkritisch und leicht zu handhaben.

Die Höhe der Arsendotierung das AsSG kann ebenfalls durch Variation der Prozeßparameter eingestellt werden. Typische Prozeßparameter sind:

| | |
|---|---|
| Temperatur<br>Prozeßdruck | 380 °C - 440 °C<br>$10^2$ - $10^5$ |
| Verdampfertemperaturen | 25 °C - 60 °C (Siliziumverbindung)<br>25 °C - 60 °C (Arsenkomponente)<br>25 °C - 90 °C (Si-O-As-Verbindung) |
| Trägergasmengen | 300 - 2000 sccm He oder $O_2$ (Siliziumverbindung)<br>100 - 1000 sccm He oder $O_2$ (Arsenverbindung)<br>300 - 3000 sccm He oder $O_2$ (Si-O-As-Verbindung) |
| $O_3$-Fluß<br>$O_3$-Konzentration<br>$O_2$-Fluß | 500 - 2500 sccm<br>6 - 15 Vol % in $O_2$<br>0 - 2000 sccm |

## Patentansprüche

**1.** Verfahren zur Erzeugung einer definierten Arsendotierung in Silizium-Halbleitersubstraten, vorzugsweise in Seitenwänden und Böden von in die Substrate geätzten Gräben mit hohem Aspektverhältnis, wobei als Diffusionsquelle eine in diesen Gräben abgeschiedene Arsenosilikatglasschicht verwendet wird, die nach der Arsenausdiffusion entfernt wird,
**dadurch gekennzeichnet**,
daß die Arsenosilikatglasschicht durch
a) ozonaktivierte thermische Zersetzung aus der Gasphase (CVD-Prozeß)
b) einer sauerstoffhaltigen elementorganischen Siliziumverbindung und einer sauerstoffhaltigen elementorganischen Arsenverbindung
c) bei einer Temperatur im Bereich von 380 °C bis 440 °C abgeschieden wird,
d) wobei der Druck auf einen Bereich zwischen $10^3$ Pa und $10^5$ Pa eingestellt wird.

**2.** Verfahren nach Anspruch 1,
**dadurch gekennzeichnet**,
daß die Siliziumverbindung aus einer der folgenden Substanzklassen ausgewählt wird:

$Si(OR)_4$ mit den Substituenten R = Alkyl
$Si(OR)_3R'$ mit den Substituenten R = Acetoxy oder Alkyl,
R' = H oder Alkyl
$(RR'SiO)_4$ mit den Substituenten R, R' = H oder Alkyl.

**3.** Verfahren nach Anspruch 1 oder 2,
**dadurch gekennzeichnet**,
daß die Arsenverbindung aus einer der folgenden Substanzklassen ausgewählt wird:
$As(OR)_3$ mit dem Substituenten R = Alkyl
$O=As(OR)_3$ mit dem Substituenten R = Alkyl.

**4.** Verfahren zur Erzeugung einer definierten Arsendotierung in Silizium-Halbleitersubstraten, vorzugsweise in Seitenwänden und Böden von in die Substrate geätzten Gräben mit hohem Aspektverhältnis, wobei als Diffusionsquelle eine in diesen Gräben abgeschiedene Arsenosilikatglasschicht verwendet wird, die nach der Arsenausdiffusion entfernt wird,
**dadurch gekennzeichnet**, daß die Arsenosilikatglasschicht durch
a) ozonaktivierte thermische Zersetzung aus der Gasphase (CVD-Prozeß)
b) einer sauerstoffhaltigen elementorganischen Silizium-Arsen-Verbindung, die die Siliziumatome und die Arsenatome bereits im vorgegebenen Verhältnis enthält,
c) bei einer Temperatur im Bereich von 380 ° C bis 440 ° C abgeschieden wird.
d) wobei der Druck auf einen Bereich zwischen $10^3$ Pa und $10^5$ Pa eingestellt wird.

**5.** Verfahren nach Anspruch 4,
**dadurch gekennzeichnet**,
daß die Silizium-Arsen-Verbindung aus einer der folgenden Substanzklassen ausgewählt wird:
$(R_3SiO)_3As$ mit den Substituenten R = H oder Alkyl
$(R_3SiO)_3As=O$ mit den Substituenten R = H oder Alkyl.

**6.** Verwendung des Vefahrens nach einem der Ansprüche 1 bis 5 zur Herstellung von grabenförmigen Kondensator-Speicherzellen (Trenchzellen),
**dadurch gekennzeichnet**,
daß die $n^+$-Dotierung (Arsen) der ersten, unteren Kondensatorelektrode den Graben (5) mit hoher Oberflächenkonzentration, aber geringer Eindringtiefe umgibt.

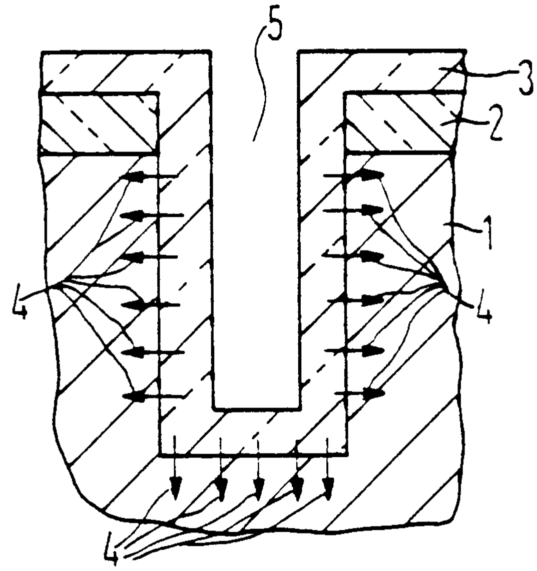
5
3
2
1
4
4
4

Europäisches Patentamt

# EUROPÄISCHER RECHERCHENBERICHT

Nummer der Anmeldung

EP 90 12 5288
Seite 1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,Y | EP-A-271072 (SIEMENS AG.)<br>* Seite 1, Zeilen 3 - 37 *<br>* Seite 4, Zeile 16 - Seite 5, Zeile 10; Ansprüche 1-3; Figuren 1-3 *<br>--- | 1-3, 6 | H01L21/225<br>H01L21/316 |
| Y | EP-A-212691 (FOCUS SEMICONDUCTOR SYSTEMS INC.)<br>* Spalte 3, Zeile 43 - Spalte 4, Zeile 51 *<br>* Spalten 13 - 16 *<br>--- | 1-3, 6 | |
| Y | EP-A-286097 (AIR PRODUCTS AND CHEMICALS INC.)<br>* Seite 3, Zeile 13 - Seite 4, Zeile 13; Ansprüche 1-6 *<br>--- | 1-3, 6 | |
| A | JOURNAL OF THE ELECTROCHEMICAL SOCIETY.<br>vol. 136, no. 10, Oktober 1989, MANCHESTER, NEW HAMP<br>Seiten 3033 - 3043; Frank S. BECKER et al.: "Low pressure deposition of doped SiO2 by pyrolysis of Tetraethylorthosilicate (TEOS)"<br>* Seiten 3034 - 3035 *<br>* Seite 3037, rechte Spalte; Figur 10 *<br>--- | 1-3, 6 | **RECHERCHIERTE SACHGEBIETE (Int. Cl.5)** |
| A | NEC RESEARCH AND DEVELOPMENT.<br>no. 94, Juli 1989, TOKYO JP<br>Seiten 1 - 7; Y. IKEDA et al.: "Ozone/Organic-source APCVD for ULSI reflow glass films"<br>* Seite 2; Figur 1 *<br>--- | 1, 2 | H01L<br>C23C |
| D,A | Proceedings of the IEEE VMIC conference 12 Juni 1989,<br>Seiten 382 - 389; Y. NISHIMOTO et al.: "Dielectric film deposition by atmospheric pressure and low temperature CVD using TEOS, ozone and new organometallic doping sources"<br>* Seiten 383 - 384; Figur 3 *<br>---<br>-/-- | 1, 2 | |

Der vorliegende Recherchenbericht wurde für alle Patentansprüche erstellt

| Recherchenort | Abschlußdatum der Recherche | Prüfer |
|---|---|---|
| BERLIN | 14 JUNI 1991 | KLOPFENSTEIN P. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)

Europäisches Patentamt

# EUROPÄISCHER RECHERCHENBERICHT

Nummer der Anmeldung

EP 90 12 5288
Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | FR-A-2172099 (IBM)<br>* Seite 1, Zeile 34 - Seite 2, Zeile 25 *<br>* Seite 3, Zeile 25 - Seite 7, Zeile 26;<br>Ansprüche 1-4, 6, 8; Figur 2 *<br>----- | 1-4 | |
| | | | RECHERCHIERTE SACHGEBIETE (Int. Cl.5 ) |

Der vorliegende Recherchenbericht wurde für alle Patentansprüche erstellt

| Recherchenort | Abschlußdatum der Recherche | Prüfer |
|---|---|---|
| BERLIN | 14 JUNI 1991 | KLOPFENSTEIN P. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.......................................................................
& : Mitglied der gleichen Patentfamilie, übereinstimmendes Dokument

EPO FORM 1503 03.82 (P0403)